(19) Europäisches Patentamt
European Patent Office
Office européen des brevets

(11) EP 4 451 344 A1

(12) EUROPEAN PATENT APPLICATION
published in accordance with Art. 153(4) EPC

(43) Date of publication:
23.10.2024 Bulletin 2024/43

(21) Application number: 22907102.2

(22) Date of filing: 11.11.2022

(51) International Patent Classification (IPC):
H01L 29/861 (2006.01)          H01L 21/329 (2006.01)
H01L 29/06 (2006.01)          H01L 29/868 (2006.01)

(52) Cooperative Patent Classification (CPC):
H01L 29/06; H01L 29/66083; H01L 29/861;
H01L 29/868

(86) International application number:
PCT/JP2022/042067

(87) International publication number:
WO 2023/112571 (22.06.2023 Gazette 2023/25)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 15.12.2021  JP 2021203203

(71) Applicant: Hitachi Power Semiconductor Device,
Ltd.
Hitachi-shi, Ibaraki 319-1221 (JP)

(72) Inventors:
• OOYANAGI, Takasumi
Tokyo 100-8280 (JP)
• FURUKAWA, Tomoyasu
Tokyo 100-8280 (JP)

(74) Representative: MERH-IP Matias Erny Reichl
Hoffmann
Patentanwälte PartG mbB
Paul-Heyse-Strasse 29
80336 München (DE)

(54) **SEMICONDUCTOR DEVICE AND POWER CONVERSION DEVICE**

(57) Provided are: a semiconductor device configured to have low ON voltage, low switching loss, and to suppress high-frequency oscillation caused by noise during switching, even if the semiconductor device is made thin; and a power conversion device using the semiconductor device. Provided is a semiconductor device comprising: a drift layer of a first conductivity type; an anode layer of a second conductivity type formed on a first main surface side of the drift layer; a field stop layer of the first conductivity type that is formed on a second main surface side of the drift layer and has a higher impurity concentration than the drift layer; and a cathode layer of the first conductivity type that has a higher impurity concentration than the field stop layer. The semiconductor device has a first defect layer for carrier lifetime control, which is formed by light ion irradiation. In the defect layer, the region from the concentration peak of the light ions to the half-value width $\Delta L_p$ of the light ion concentration profile does not overlap the depletion layer spreading in the drift layer, and does not overlap the location in the field stop layer where the first conductivity type carrier concentration is 1016cm-3.

FIG. 1

**Description**

Technical Field

The present invention relates to a semiconductor device and a power conversion device.

Background Art

A vertical semiconductor device such as an IGBT (Insulated Gate Bipolar Transistor) and a PIN diode (P-Intrinsic-N diode) has a vertical structure in which a current flows in a vertical direction. In the IGBT, a region including an N-type drift layer, an N-type buffer layer, and a P-type collector layer has a vertical structure, and in the diode, a region including a P+ anode layer, an N-type drift layer, an N-type buffer layer, and an N+ cathode layer has a vertical structure.

In order to reduce an on-voltage and a switching loss of the semiconductor device, it is effective to reduce a thickness of the N-type drift layer. However, as for the switching noise, when a current drop at the time of switching is rapid and a natural extinction period of an accumulation carrier called a tail current is not particularly secured, there is a problem that the current rapidly disappears, a surge voltage (L-dI/dt) proportional to a parasitic inductance in a main circuit is generated, and oscillation occurs at a frequency of several MHz or more. These noises may cause motor insulation, overvoltage element breakdown, element malfunction, and the like.

PTL 1 is an example of a conventional technique for reducing loss and noise of a semiconductor device. PTL 1 discloses a semiconductor device including: a first conductivity type semiconductor substrate; a first conductivity type drift layer disposed on the semiconductor substrate on a side of a first main surface; a second conductivity type anode layer selectively disposed along the drift layer and having a resistance that is lower than a resistance of the drift layer; a first conductivity type cathode layer disposed on a surface layer of the semiconductor substrate on a side of a second main surface, the cathode layer being in contact with the drift layer; and a vacancy-oxygen complex defect region configured by a complex defect of vacancies and oxygen, wherein the vacancy-oxygen complex defect region is represented by $0 < R \leq t - W$, with respect to W, where a depth in a direction from a boundary surface between the cathode layer and the drift layer toward the first main surface of the semiconductor substrate is R, a specific resistance of the semiconductor substrate is $\rho$, a thickness from a pn junction between the anode layer and the drift layer to the cathode layer is t, and a depletion layer width spreading from the pn junction into the drift layer at a reverse bias voltage V applied to the pn junction is $0.54 \times$ & $(\rho \times V)$ (where $\rho$ is resistivity and V is reverse bias voltage). According to the above configuration of PTL 1, it is considered that both the reduction of the switching loss and the soft recovery characteristics can be obtained by an inexpensive and simple process.

Citation List

Patent Literature

PTL 1: WO 2016/035531 A

Summary of Invention

Technical Problem

However, it has been found that in PTL 1, when W is calculated with each resistivity and reverse bias voltage, and a minimum device thickness of the semiconductor device in which the vacancy-oxygen complex defect region is provided at a depth represented by $0 < R \leq t - W$ is calculated, there is a limit in thinning particularly in a high voltage region.

In view of the above circumstances, an object of the present invention is to provide a semiconductor device capable of suppressing radio-frequency oscillation due to reduction of an on-voltage, reduction of a switching loss, and noises during switching even when a thickness of the semiconductor device is reduced, and a power conversion device using such a semiconductor device.

Solution to Problem

One aspect of a semiconductor device of the present invention for solving the above problems is a semiconductor device including: a semiconductor substrate having a drift layer of a first conductivity type; an anode layer of a second conductivity type disposed on the drift layer on a first main surface side; a field stop layer of the first conductivity type disposed on the drift layer on a second main surface side, the field stop layer having an impurity concentration higher than an impurity concentration of the drift layer; and a cathode layer of the first conductivity type, the cathode layer having an impurity concentration higher than an impurity concentration of the field stop layer, wherein the semiconductor device includes a first defective layer for carrier lifetime control provided by irradiation of light ions, and in the defective layer, a region from a concentration peak of the light ions to a half width $\Delta Lp$ of a concentration profile of the light ions fails to cover a depletion layer that spreads within the drift layer, and a carrier concentration of the first conductivity type of the field stop layer fails to cover a position of $10^{16}$ cm$^{-3}$.

The present invention also provides a power conversion device using the semiconductor device according to the present invention described above.

A more specific configuration of the present invention is described in the claims.

Advantageous Effects of Invention

According to the present invention, it is possible to provide a semiconductor device capable of suppressing radio-frequency oscillation due to reduction of an on-voltage, reduction of a switching loss, and noises during switching even when a thickness of the semiconductor device is reduced, and a power conversion device using such a semiconductor device.

Problems, configurations, and effects other than those described above will become apparent from the following description of embodiments.

Brief Description of Drawings

[FIG. 1] FIG. 1 is a sectional view of a semiconductor device according to a first embodiment, and a graph showing distributions of an n-type concentration (Cn) and a light ion concentration (In).
[FIG. 2] FIG. 2 is a manufacturing flowchart showing an example of a method of manufacturing the semiconductor device according to the first embodiment.
[FIG. 3] FIG. 3 is a graph showing a relationship between an n-type carrier concentration and a carrier lifetime.
[FIG. 4] FIG. 4 is a graph showing a relationship between an implantation position depth of light ions, a recovery loss RL, and a ringing peak voltage VLp.
[FIG. 5] FIG. 5 is a graph showing a recovery waveform in the first embodiment.
[FIG. 6] FIG. 6 is a sectional view of a semiconductor device according to a second embodiment and a graph showing distributions of an n-type concentration (Cn) and a light ion concentration (In).
[FIG. 7] FIG. 7 is a graph showing a recovery waveform in the second embodiment.
[FIG. 8] FIG. 8 is a circuit diagram showing a schematic configuration of a power conversion device of the present invention.

Description of Embodiments

Hereinafter, the present invention will be described in detail with reference to the drawings.

[First Embodiment]

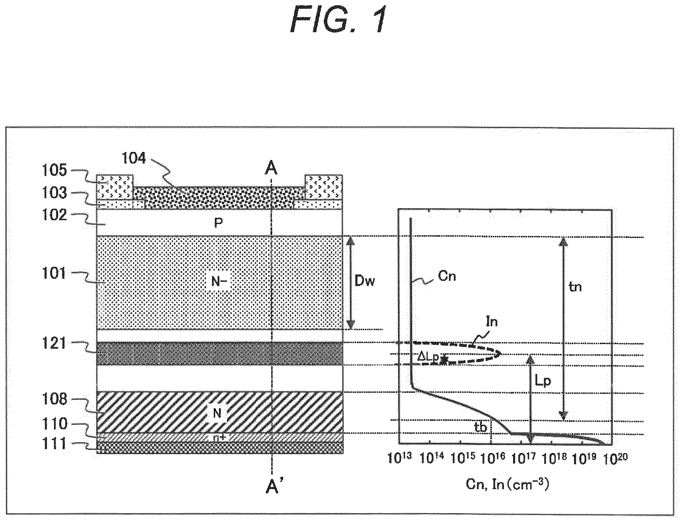

FIG. 1 is a sectional view of a semiconductor device according to a first embodiment, and a graph showing distributions of an n-type concentration (Cn) and a light ion concentration (In). In the present embodiment, a PIN diode is taken as an example of the semiconductor device.

As described above, a semiconductor device according to the present invention includes: a semiconductor substrate having a drift layer of a first conductivity type (n-type); an anode layer 102 of a second conductivity type (p-type) disposed on the drift layer on a first main surface side; a field stop layer 108 of the first conductivity type disposed on the drift layer on a second main surface side, the field stop layer 108 having an impurity concentration higher than an impurity concentration of the drift layer; and a cathode layer 110 of the first conductivity type, the cathode layer having an impurity concentration higher than an impurity concentration of the field stop layer, wherein the semiconductor device includes a first defective layer 121 for carrier lifetime control provided by irradiation of light ions, and in the defective layer 121, a region from a concentration peak of the light ions to a half width $\Delta Lp$ of a concentration profile of the light ions fails to cover a depletion layer that spreads within the drift layer 101, and a carrier concentration of the first conductivity type of the field stop layer 108 fails to cover a position of $10^{16}$ cm$^{-3}$.

More specifically, the defective layer 121 is disposed in a depth range represented by the following Expression (1), where a distance of a concentration peak of the light ions from the second main surface side is Lp, the half width of the concentration profile of the light ions is $\Delta$Lp, a resistivity of the drift layer 101 is $\rho$, a power supply voltage during recovery switching is V, a thickness from the second principal surface side of a layer including the drift layer 101, the field stop layer 108, and the cathode layer 110 at a position where the carrier concentration of the first conductivity type is $10^{16}$ cm$^{-3}$ is tb, a thickness to the anode layer 102 from a position where the carrier concentration of the first conductivity type is $10^{16}$ cm$^{-3}$ is tn, and a thickness Dw of the depletion layer that spreads within the drift layer 101 is $0.322 \times \& (\rho \times V)$.

$$\Delta Lp + tb < Lp < tn - 0.322 \times \sqrt{(\rho \times V)} - \Delta Lp \bullet\bullet\bullet (1)$$

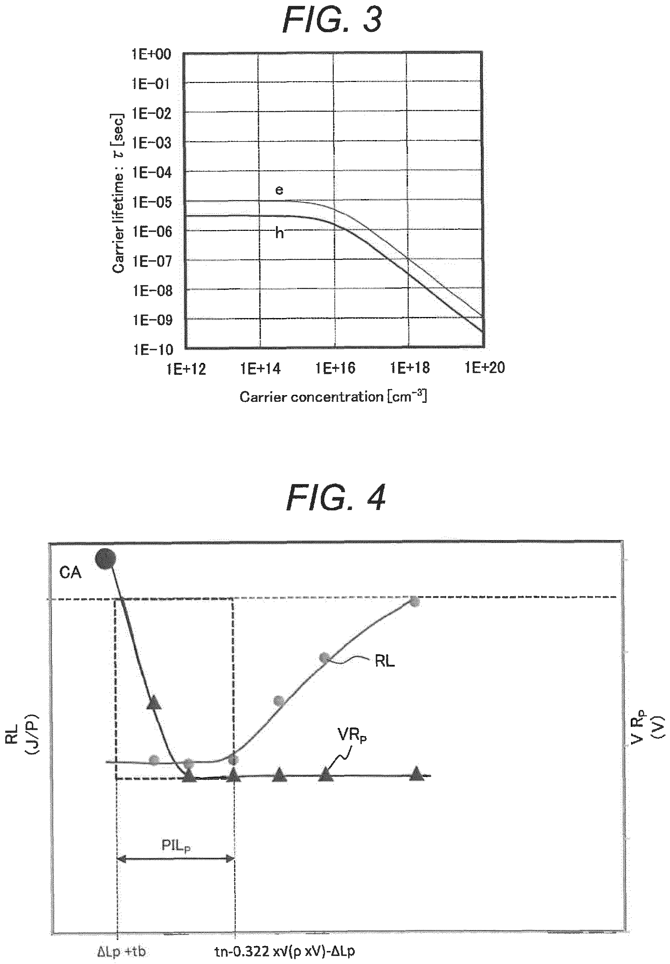

FIG. 3 is a graph showing a relationship between an n-type carrier concentration (horizontal axis) and a carrier lifetime (vertical axis). As illustrated in FIG. 3, when the carrier concentration (electron e, hole h) is equal to or higher than $1 \times 10^{16}$ cm$^{-3}$, the carrier lifetime is rapidly reduced as the carrier concentration is higher. The lifetime is further reduced as a defect due to irradiation of light ions is provided at a position where the concentration is $10^{16}$ cm$^{-3}$, and as a result, reverse recovery switching of the diode is deteriorated. Therefore, it is desirable that the defective layer 121 provided by irradiation of light ions takes a certain distance from the position where the concentration is $10^{16}$ cm$^{-3}$.

FIG. 4 is a graph showing a relationship between an implantation position depth (horizontal axis) of light ions, a recovery loss RL (left vertical axis), and a ringing peak voltage VRp (right vertical axis). As shown in FIG. 4, it can be seen that in an existence range (PILp) of Lp of the present invention, the recovery loss RL and the ringing peak voltage VRp are lower than those in the conventional case (CA).

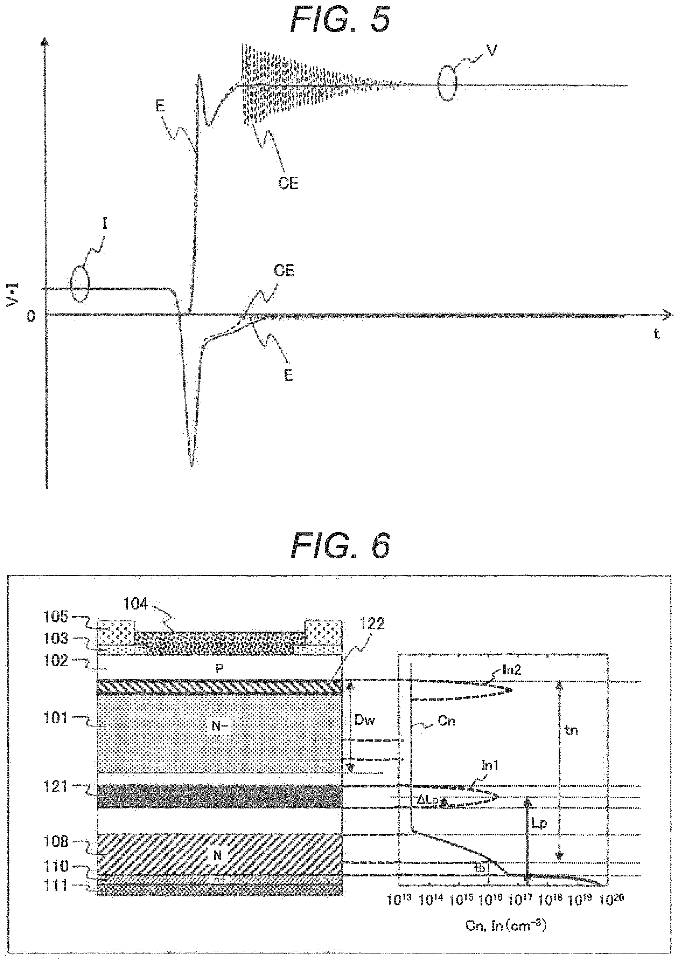

FIG. 5 is a graph showing a recovery waveform in the first embodiment. FIG. 5 shows temporal changes of a current I and a voltage V when a state in which the voltage is applied in a forward direction is changed to a reverse bias state. The graph indicated by a solid line E corresponds to the present embodiment, and a graph indicated by a broken line CE corresponds to a comparative example. As shown in FIG. 5, according to the configuration of the present invention, it is possible to reduce noises at the time of diode recovery for both the current I and the voltage V.

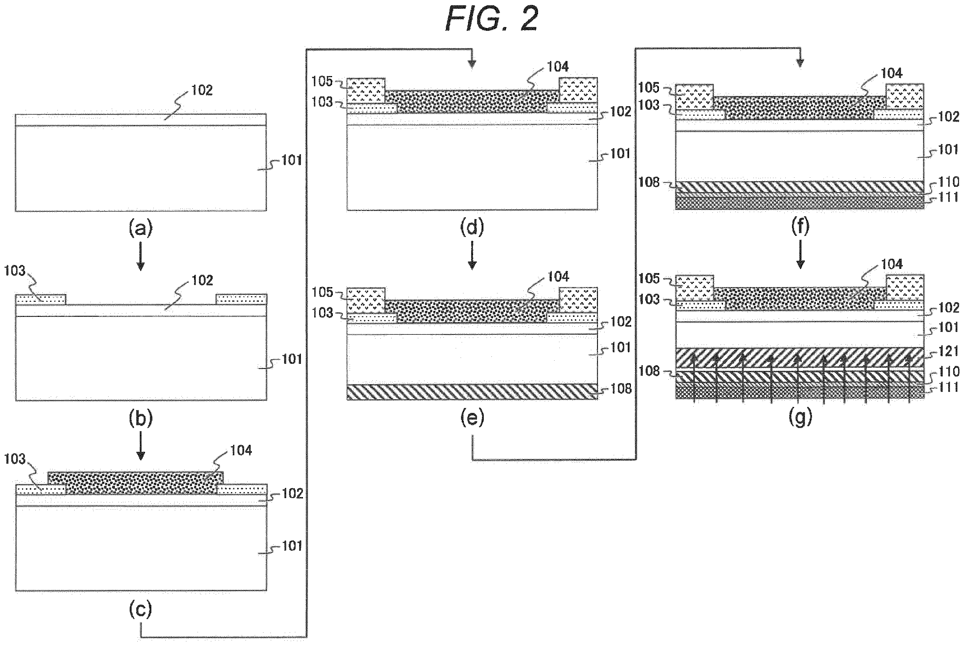

Next, a method for manufacturing the semiconductor device of the present embodiment described above will be described. FIG. 2 is a manufacturing flowchart showing an example of a method of manufacturing the semiconductor device according to the first embodiment. A manufacturing process of a PIN diode of the present invention will be described along with a sectional structure of the semiconductor device with reference to FIG. 2. First, in FIG. 2(a), a silicon (Si) wafer for manufacturing a PIN diode is prepared. For example, a thickness of the Si wafer is 725 $\mu$m for an 8-inch wafer, and 775 $\mu$m for a 12-inch wafer. Here, the Si wafer described above has the drift layer 101 having a specific resistance according to a withstand voltage. For example, the specific resistance can be set to about 55 Gem for a diode having a withstand voltage of 1.2 kV, and about 250 Qcm for a diode having a withstand voltage of 3.3 kV. In a first step that is not illustrated, a silicon oxide film is formed on the entire surface of the Si substrate by thermal oxidation.

Next, a photolithography process for forming a region where the anode P-type semiconductor layer 102 is provided is performed. In the photolithography process, a resist in which a region for providing the anode P-type semiconductor layer 102 is opened is formed by applying, exposing, and developing a resist material on the surface of the Si substrate. Thereafter, p-type impurity ions are implanted. Examples of the p-type impurity ions include boron (B) ions. Thereafter, the resist is removed, and annealing to activate impurities is performed to form the anode P-type semiconductor layer 102 as illustrated in FIG. 2(a).

Next, as shown in FIG. 2(b), a silicon oxide film 103, for example, is deposited on the Si substrate by a silicon oxide film formation by thermal oxidation, and by a chemical vapor deposition (CVD; Chemical Vapor Deposition) method, and a photolithography process for forming a contact portion for connecting the anode P-type semiconductor layer 102 and an anode electrode is performed. By etching the silicon oxide film 103 using the resist formed by applying, exposing, and developing the resist material as a mask, the contact portion for connecting the anode P-type semiconductor layer 102 and the anode electrode is formed.

Subsequently, as illustrated in FIG. 1(c), an anode electrode made of aluminum (Al) or an Al alloy is formed by film formation by a sputtering method, a resist is patterned and etched by a photolithography process, and thus the anode electrode 104 is formed.

Next, as shown in FIG. 1(d), a surface protective film 105 is formed. In a method for forming the protective film, the protective film can be formed by applying and exposing a solution containing a polyimide precursor material and a photosensitive material to polyimidize the precursor, for example.

Next, as shown in FIG. 1(e), the Si wafer is thinned by back grinding and a mixed solution of hydrofluoric acid/nitric acid. Thereafter, the n-type field stop layer (n buffer layer) 108 is formed by ion implantation from a back surface side. According to the study by the inventors, when a depth of the n-type field stop layer 108 is equal to or less than 7 um, an increase in leakage current occurs at the time of holding the withstand voltage due to a manufacturing process after the next step or a scratch on the back surface generated in an inspection step, and the processing accuracy of the back grinding and the hydrofluoric acid/nitric acid mixed solution is approximately $\pm$ 3 $\mu$m. Therefore, it is desirable that the depth of the n-type field stop layer 108 is equal to or more than 10 um in consideration of processing variations.

Subsequently, as shown in FIG. 1(f), n-type impurity ions are implanted from the opposite side (second main surface side) of a main surface on which the anode P-type semiconductor layer 102 is disposed (first main surface). Examples of the n-type impurity ions include phosphorus (P) ions and arsenic (As) ions. Thereafter, laser annealing is performed to activate the ion-implanted n-type impurity, and the semiconductor layer 110 of an n+ type is formed. A cathode electrode 111 is formed by sputtering in a laminated structure of AlSi alloy/titanium (Ti)/nickel (Ni)/gold (Au), for example.

Next, as shown in FIG. 1(g), light ions (proton, helium, etc.) are irradiated from the opposite side (second main surface side) of the main surface on which h the anode P-type semiconductor layer 102 is formed to form a light ion implantation layer (defective layer) 121.

Here, in the irradiation of light ions, an irradiation energy and an irradiation amount of the light ions are adjusted such that a defect position after an annealing treatment falls within the above-described range. In addition, the irradiation of light ions may be performed after preliminary polishing in which processing is performed in a range (for example, a thickness of 600 $\mu$m) in which wafer cracking due to the weight caused by an increase in diameter and excessive warpage do not occur. The irradiation of light ions may be performed after FIG. 1(d) or after FIG. 1(e).

[Second Embodiment]

FIG. 6 is a sectional view of a semiconductor device according to a second embodiment and a graph showing distributions of an n-type concentration (Cn) and a light ion concentration (In). In the present embodiment, a defective layer (second defective layer) 122 that performs lifetime control on an anode side is provided in addition to the defective layer (first defective layer) 121 that performs lifetime control on a cathode side.

When a drive element of the IGBT element is high speed, a recovery switch is also high speed and a recovery peak voltage increases, and thus noises may occur at di/dt at this time. In this case, by light ion implantation on the anode side, hole implantation on the anode side is suppressed to suppress the peak voltage, and as a result, it is possible to reduce recovery noises.

In order to realize the suppression of a recovery tail current and an increase in the switching speed due to the reduction in thickness, it is desirable to provide a structure in which a peak of a light ion concentration In2 of the second defective layer 122 is larger than a peak of a light ion concentration In1 of the first defective layer 121. With the above relationship, the lifetime is relatively long on the cathode side, and the maximum recovery current can be reduced while suppressing a steep change in the recovery tail current, and therefore noises can be suppressed even in a higher-speed recovery switch.

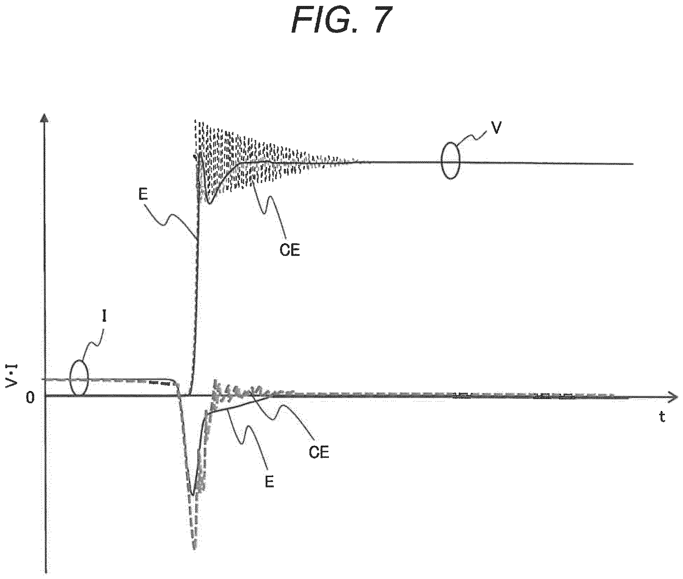

FIG. 7 is a graph showing a recovery waveform in the second embodiment. As illustrated in FIG. 7, according to the configuration of the present embodiment, noises can be reduced at the time of diode recovery.

[Third Embodiment]

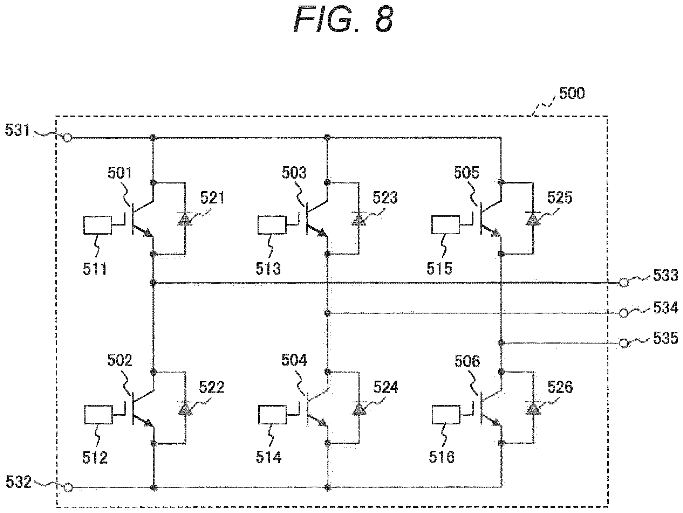

FIG. 8 is a circuit diagram showing a schematic configuration of a power conversion device of the present invention. FIG. 8 illustrates an example of a circuit configuration of a power conversion device 500 of the present embodiment and a connection relationship between a DC power supply and a three-phase AC motor (AC load).

In the power conversion device 500 of the present embodiment, the semiconductor device of the present invention is used as elements 521-526 (for example, diodes).

As illustrated in FIG. 8, the power conversion device 500 of the present embodiment includes a P terminal 531 and an N terminal 532 which are a pair of DC terminals, and a U terminal 533, a V terminal 534, and a W terminal 535 which are AC terminals of a number identical to the number of phases of an AC output.

The power conversion device 500 also includes a switching leg configured by series connection of the pair of power switching elements 501 and 502 and having the U terminal 533 connected to a series connection point thereof as an output. The power conversion device 500 also includes a switching leg configured by series connection of the power switching elements 503 and 504 having the same configuration, and having the V terminal 534 connected to a series connection point thereof as an output is provided. The power conversion device 500 also includes a switching leg configured by series connection of the power switching elements 505 and 506 having the same configuration, and having the W terminal 535 connected to a series connection point thereof as an output is provided.

The switching legs for three phases including the power switching elements 501-506 are connected between the DC terminals of the P terminal 531 and the N terminal 532, and DC power is supplied from a DC power supply that is not illustrated. The U terminal 533, the V terminal 534, and the W terminal 535, which are the three-phase AC terminals of the power conversion device 500, are connected to the three-phase AC motor that is not illustrated as a three-phase AC power supply.

The diodes 521-526 are respectively connected in antiparallel to power switching elements 501-506. Gate circuits 511-516 are respectively connected to input terminals of gates of the power switching elements 501-506 constituted by IGBTs, for example, and the power switching elements 501-506 are respectively controlled by the gate circuits 511-516. The gate circuits 511-516 are integrally controlled by an integrated control circuit that is not illustrated.

The power switching elements 501-506 are integrally and appropriately controlled by the gate circuits 511-516, and DC power of the DC power supply Vcc is converted into three-phase AC power and is output through the U terminal 533, the V terminal 534, and the W terminal 535.

By applying the semiconductor device of the present invention to the power conversion device 500, it is possible to improve reduction of an on-voltage and reduction of a switching loss, and to suppress radio-frequency oscillation due to noises during switching, even when a thickness of the semiconductor device is reduced.

As described above, according to the present invention, it has been shown that it is possible to provide a semiconductor device capable of suppressing radio-frequency oscillation due to reduction of an on-voltage, reduction of a switching loss, and noises during switching even when a thickness of the semiconductor device is reduced, and a power conversion device using such a semiconductor device.

Note that the present invention is not limited to the above-described embodiments, and includes various modifications. For example, the above-described embodiments have been described in detail in order to describe the present invention in an easy-to-understand manner, and are not necessarily intended to limit to those having all of the described configurations. Further, a part of one configuration of a certain embodiment can be replaced with a configuration of a different embodiment, and a configuration of one embodiment can be added to a configuration of a different embodiment. In addition, it is possible to add, delete, and replace other configurations for a part of the configuration of each embodiment.

For example, in the present specification, "first conductivity type" has been described as "n-type" and "second conductivity type" has been described as "p-type". However, the "first conductivity type" and the "second conductivity type" may be "p-type" and "n-type", respectively. Reference Signs List

- 101 drift layer
- 102 anode layer
- 103 silicon oxide film
- 104 anode electrode
- 105 surface protective film
- 108 field stop layer
- 110 cathode layer
- 121 defective layer
- Dw thickness of depletion layer
- $\Delta Lp$ half width of concentration profile of light ions
- 500 power conversion device
- 501 to 506 power switching element
- 511 to 516 gate circuit
- 521 to 526 diode
- 531 P terminal
- 532 N terminal
- 533 U terminal
- 534 V terminal
- 535 W terminal

## Claims

1. A semiconductor device comprising:

   a semiconductor substrate having a drift layer of a first conductivity type;
   an anode layer of a second conductivity type disposed on the drift layer on a first main surface side;
   a field stop layer of the first conductivity type disposed on the drift layer on a second main surface side, the field stop layer having an impurity concentration higher than an impurity concentration of the drift layer; and
   a cathode layer of the first conductivity type, the cathode layer having an impurity concentration higher than an impurity concentration of the field stop layer,
   wherein
   the semiconductor device includes a first defective layer for carrier lifetime control provided by irradiation of light ions, and
   in the defective layer, a region from a concentration peak of the light ions to a half width $\Delta Lp$ of a concentration

profile of the light ions fails to cover a depletion layer that spreads within the drift layer, and a carrier concentration of the first conductivity type of the field stop layer fails to cover a position of $10^{16}$ cm$^{-3}$.

2. The semiconductor device according to claim 1, wherein the defective layer is disposed in a depth range represented by:

$$\Delta Lp + tb < Lp < tn - 0.322 \times \sqrt{(\rho \times V)} - \Delta Lp \quad \bullet\bullet\bullet \quad (1)$$

where a distance of a concentration peak of the light ions from the second main surface side is Lp, a resistivity of the drift layer is ρ, a power supply voltage during recovery switching is V, a thickness from the second principal surface side of a layer including the drift layer, the field stop layer, and the cathode layer at a position where the carrier concentration of the first conductivity type is $10^{16}$ cm$^{-3}$ is tb, a thickness to the anode layer from a position where the carrier concentration of the first conductivity type is $10^{16}$ cm$^{-3}$ is tn, and a thickness Dw of the depletion layer that spreads within the drift layer is $0.322 \times \sqrt{(\rho \times V)}$.

3. The semiconductor device according to claim 1, further comprising a second defective layer in addition to the first defective layer, the second defective layer being disposed in the depletion layer in the drift layer, the second defective layer being for the carrier lifetime control.

4. The semiconductor device according to claim 3, wherein a peak of light ion concentration constituting the second defective layer is larger than a concentration peak of light ions constituting the first defective layer.

5. A power conversion device comprising:

a pair of DC terminals;
AC terminals, a number of the AC terminals being identical with a number of phases of an AC output;
switching legs to which two parallel circuits are connected in series, each of the parallel circuits including a switching element and a diode connected in antiparallel to the switching element, the switching legs being connected between the pair of DC terminals, a number of the switching legs being identical with the number of phases of the AC output; and
a gate circuit configured to control the switching element,
wherein the diode is the semiconductor device according to one of claims 1 to 4.

# FIG. 1

# FIG. 2

(a)

(b)

(c)

(d)

(e)

(f)

(g)

EP 4 451 344 A1

## FIG. 3

## FIG. 4

# FIG. 5

# FIG. 6

# FIG. 7

# FIG. 8

## INTERNATIONAL SEARCH REPORT

| International application No. |
| --- |
| **PCT/JP2022/042067** |

**A.    CLASSIFICATION OF SUBJECT MATTER**

*H01L 29/861*(2006.01)i; *H01L 21/329*(2006.01)i; *H01L 29/06*(2006.01)i; *H01L 29/868*(2006.01)i
FI:   H01L29/91 J; H01L29/91 C; H01L29/91 A; H01L29/06 301V; H01L29/06 301D

According to International Patent Classification (IPC) or to both national classification and IPC

**B.    FIELDS SEARCHED**

Minimum documentation searched (classification system followed by classification symbols)

H01L29/861; H01L21/329; H01L29/06; H01L29/868

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| Y | WO 2016/035531 A1 (FUJI ELECTRIC CO LTD) 10 March 2016 (2016-03-10) paragraphs [0018], [0020], [0040]-[0060], fig. 1, 2, 7, 8 | 1, 3-5 |
| A |  | 2 |
| Y | JP 2017-135339 A (DENSO CORP) 03 August 2017 (2017-08-03) paragraphs [0018]-[0060], fig. 1-5 | 1, 3-5 |
| A |  | 2 |
| Y | JP 2011-049300 A (TOYOTA MOTOR CORP, SUMIJU SHIKEN KENSA KK) 10 March 2011 (2011-03-10) paragraphs [0036]-[0041], fig. 7-10 | 3-5 |
| A |  | 1, 2 |
| Y | JP 2017-201644 A (HITACHI LTD, HITACHI POWER SEMICONDUCTOR DEVICE LTD) 09 November 2017 (2017-11-09) paragraphs [0050]-[0052], fig. 12 | 5 |
| A |  | 1-4 |

☐ Further documents are listed in the continuation of Box C.    ☑ See patent family annex.

| \* | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **23 January 2023** | **31 January 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2022/042067**

| Patent document cited in search report | | | Publication date (day/month/year) | Patent family member(s) | Publication date (day/month/year) |
|---|---|---|---|---|---|
| WO | 2016/035531 | A1 | 10 March 2016 | US 2016/0365250 A1 paragraphs [0022], [0024], [0046]-[0066], fig. 1, 2, 7, 8 CN 106062966 A | |
| JP | 2017-135339 | A | 03 August 2017 | US 2017/0222029 A1 paragraphs [0035]-[0077], fig. 1-5 | |
| JP | 2011-049300 | A | 10 March 2011 | (Family: none) | |
| JP | 2017-201644 | A | 09 November 2017 | US 2017/0317075 A1 paragraphs [0170]-[0180], fig. 12 CN 107342329 A | |

Form PCT/ISA/210 (patent family annex) (January 2015)

**REFERENCES CITED IN THE DESCRIPTION**

**Patent documents cited in the description**

- WO 2016035531 A